(19) Europäisches Patentamt
European Patent Office
Office européen des brevets

(11) EP 3 401 346 B1

(12) # EUROPEAN PATENT SPECIFICATION

(45) Date of publication and mention of the grant of the patent:
**30.06.2021 Bulletin 2021/26**

(51) Int Cl.:
*C08G 59/50* (2006.01) *C08G 59/68* (2006.01)
*C08G 59/70* (2006.01)

(21) Application number: **18170802.5**

(22) Date of filing: **04.05.2018**

(54) **EPOXY RESIN COMPOSITION AND SEMICONDUCTOR DEVICE**

EPOXIDHARZZUSAMMENSETZUNG UND HALBLEITERBAUELEMENT

COMPOSITION DE RÉSINE ÉPOXY ET DISPOSITIF À SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.05.2017 JP 2017093663**

(43) Date of publication of application:
**14.11.2018 Bulletin 2018/46**

(73) Proprietor: **Shin-Etsu Chemical Co., Ltd.**
**Tokyo (JP)**

(72) Inventors:
- **KUSHIHARA, Naoyuki**
  **Annaka-shi, Gunma (JP)**
- **SUMITA, Kazuaki**
  **Annaka-shi, Gunma (JP)**
- **YAJIMA, Akira**
  **Annaka-shi, Gunma (JP)**

(74) Representative: **Ter Meer Steinmeister & Partner**
**Patentanwälte mbB**
**Nymphenburger Straße 4**
**80335 München (DE)**

(56) References cited:
**EP-A1- 2 508 546** **WO-A2-95/05411**
**US-A1- 2003 116 347** **US-B1- 6 632 881**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 401 346 B1

## Description

CROSS-REFERENCE TO RELATED APPLICATION

This non-provisional application claims priority under 35 U.S.C. §119(a) on Patent Application No. 2017-093663 filed in Japan on May 10, 2017.

TECHNICAL FIELD

This invention relates to a thermosetting epoxy resin composition, and more particularly, to an epoxy resin composition used for encapsulating semiconductor devices such as diodes, transistors, ICs, LSIs and VLSIs.

BACKGROUND ART

Epoxy resins are used as semiconductor encapsulant in a wide variety of applications. With the progress toward miniaturization and higher density of semiconductor chips, the encapsulant is desired to have higher reliability. For improving productivity, there is a need for an epoxy resin which quickly cures at low temperature. As a low-temperature quick-curing epoxy resin composition, Patent Document 1 discloses a two-pack epoxy resin composition which cures after mixing of two components, i.e., an epoxy resin and a curing agent. Although the two-pack epoxy resin composition has excellent low-temperature curability, it must be intimately mixed before it can exert the properties fully. Also, since its working life after mixing is limited, there are restrictions on usage.

To solve these problems, Patent Document 2 proposes a one-pack epoxy resin composition using a microcapsule type curing agent. However, since the microcapsule type curing agent is solid or highly viscous liquid, the resin composition may become too viscous to work.

Citation List

Patent Document 1: JP-A 2016-060826
Patent Document 2: JP-A 2015-113426

SUMMARY OF INVENTION

An object of the invention is to provide an epoxy resin composition which has low-temperature curability and workability and is improved in adhesion and adhesion retention, and a semiconductor device encapsulated therewith.

The inventors have found that the outstanding problem is solved by an epoxy resin composition comprising (A) an epoxy resin, (B) an aromatic amine-based curing agent, and (C) a curing accelerant in the form of an arylborate salt as described in claim 1.

In one aspect, the invention provides an epoxy resin composition comprising (A) an epoxy resin, (B) an aromatic amine-based curing agent, and (C) a curing accelerant, an equivalent ratio of amino groups in the aromatic amine-based curing agent (B) to epoxy groups in the epoxy resin (A) being from 0.7/1 to 1.5/1, and the curing accelerant (C) comprising an arylborate salt.

Component (B) is at least one aromatic amine-based curing agent selected from the formulae (1), (2), (3) and (4):

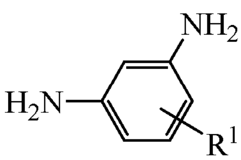

(1)

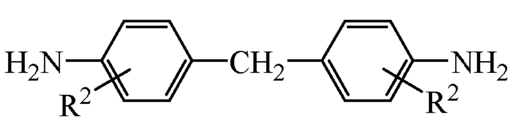

(2)

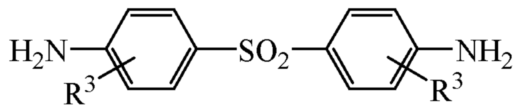

(3)

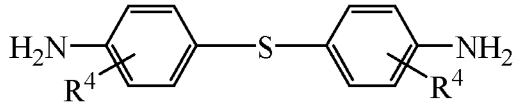

(4)

wherein $R^1$ is selected from C1 -C6 monovalent hydrocarbon groups, $CH_3$ S-, and $CH_3$ $CH_2$ S-, and $R^2$ to $R^4$ which may be the same or different are selected from hydrogen, C1 -C6 monovalent hydrocarbon groups, $CH_3$ S-, and $CH_3$ $CH_2$ S-.

In a preferred embodiment, the arylborate salt as component (C) contains at least one member selected from the group consisting of alkali metals, alkyl ammonium compounds, imidazolium compounds, arylphosphonium compounds, and alkylphosphonium compounds. Typically, component (C) is tetraphenylphosphonium tetraphenylborate, tetraphenylphosphonium tetra-p-tolylborate or triphenylphosphine triphenylborane. Preferably, component (C) is blended in an amount of 0.1 to 10 parts by weight per 100 parts by weight components (A) and (B) combined.

In a preferred embodiment, the epoxy resin (A) is a liquid epoxy resin.

The epoxy resin composition may further comprise (D) an inorganic filler.

Most often, the epoxy resin composition is liquid at 25°C.

Also contemplated herein is a semiconductor device encapsulated with the epoxy resin composition in the cured state.

## ADVANTAGEOUS EFFECTS OF INVENTION

The epoxy resin composition has both low-temperature curability and workability and is also improved in adhesion and adhesion retention. A semiconductor device encapsulated with a cured product of the epoxy resin composition is reliable.

## DESCRIPTION OF PREFERRED EMBODIMENTS

As used herein, the notation (Cn-Cm) means a group containing from n to m carbon atoms per group.

The epoxy resin composition of the invention is defined as comprising (A) an epoxy resin, (B) an aromatic amine-based curing agent, and (C) a curing accelerant.

### (A) Epoxy resin

The epoxy resin used herein as component (A) may be selected from well-known epoxy resins. Examples include bisphenol A type epoxy resins, bisphenol F type epoxy resins, bisphenol S type epoxy resins, phenol novolac type epoxy resins, cresol novolac type epoxy resins, bisphenol A novolac type epoxy resins, bisphenol F novolac type epoxy resins, stilbene type epoxy resins, triazine skeleton-containing epoxy resins, fluorene skeleton-containing epoxy resins, triphenolphenolmethane type epoxy resins, biphenyl type epoxy resins, xylylene type epoxy resins, biphenylaralkyl type epoxy resins, naphthalene type epoxy resins, dicyclopentadiene type epoxy resins, alicyclic epoxy resins, diglycidyl ether compounds of polyfunctional phenols and polycyclic aromatics such as anthracene, and phosphorus-containing epoxy resins which are obtained by introducing a phosphorus compound to the forgoing resins. These resins may be used alone or in admixture of two or more.

Component (A) is preferably a liquid resin having a viscosity at 25°C of 0.01 to 100,000 mPa·s, more preferably 0.1 to 10,000 mPa·s. Notably the viscosity is measured according to JIS Z-8803: 2011, by a cone-plate rotational viscometer (Type E viscometer) at a temperature of 25°C, after 2 minutes from sample loading.

Preferably component (A) is present in an amount of 30 to 80% by weight, more preferably 40 to 75% by weight, and even more preferably 45 to 70% by weight based on the resin composition.

### (B) Aromatic amine-based curing agent

Component (B) which is a curing agent for component (A) is an aromatic amine-based curing agent, specifically an aromatic ring-containing amine compound having heat resistance and storage stability. The aromatic amine-based curing agents include those having the following formulae (1) to (4).

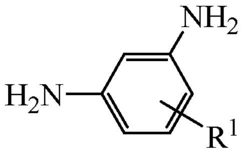

(1)

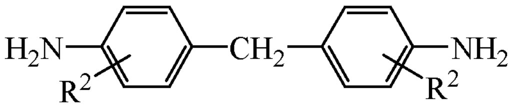

(2)

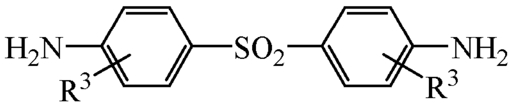

(3)

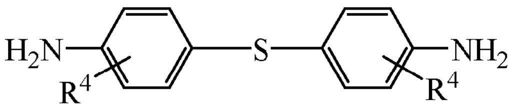

(4)

Herein $R^1$ is selected from C1 -C6 monovalent hydrocarbon groups, $CH_3$ S-, and $CH_3$ $CH_2$ S-, and $R^2$ to $R^4$ which may be the same or different are selected from hydrogen, C1 -C6 monovalent hydrocarbon groups, $CH_3$ S-, and $CH_3$ $CH_2$ S-.

Of the aromatic amine-based curing agents having formulae (1), (2), (3) and (4), preferred are aromatic diaminodiphenylmethane compounds such as 3,3'-diethyl-4,4'-diaminodiphenylmethane, 3,3',5,5'-tetramethyl-4,4'-diaminodiphenylmethane, and 3,3',5,5'-tetraethyl-4,4'-diaminodiphenylmethane, 2,4-diaminotoluene, 1,4-diaminobenzene, and 1,3-diaminobenzene. They may be used alone or in admixture of two or more.

The aromatic amine-based curing agent which is liquid at normal temperature (20-30°C) may be blended as such. However, if the aromatic amine-based curing agent which is solid is blended in an epoxy resin as such, the resin builds up its viscosity and thus becomes difficult to work. It is thus preferred that the solid curing agent is previously melt mixed with the liquid epoxy resin. Melt mixing is desirably performed at a specific blending ratio described below at a temperature of 70 to 150°C for 1 to 2 hours. If the mixing temperature is lower than 70°C, the curing agent may not be fully compatibilized with the epoxy resin. If the mixing temperature exceeds 150°C, the curing agent may react with the liquid epoxy resin, leading to a viscosity buildup. If the mixing time is shorter than 1 hour, the curing agent may not be fully compatibilized with the epoxy resin, inviting a viscosity buildup. If the mixing time exceeds 2 hours, the curing agent may react with the liquid epoxy resin, leading to a viscosity buildup.

The aromatic amine-based curing agent is blended in such an amount that an equivalent ratio of all amino groups in the aromatic amine-based curing agent to all epoxy groups in component (A) ranges from 0.7/1 to 1.5/1, preferably from 0.7/1 to 1.2/1, more preferably from 0.7/1 to 1.1/1, even more preferably from 0.85/1 to 1.05/1. If the equivalent ratio is less than 0.7, some epoxy groups may be left unreacted, resulting in a lowering of glass transition temperature (Tg) or degradation of adhesion. If the equivalent ratio exceeds 1.5, the cured epoxy resin may become hard and brittle, with the risk of cracking during reflow or thermal cycling.

(C) Curing accelerant

The curing accelerant (C) is an arylborate salt. The resin composition comprising an arylborate salt as curing accelerant (C) has low-temperature curability and improved workability due to no substantial acceleration of viscosity buildup rate, as well as excellent adhesion and adhesion retention after hot humid storage. It is thus successful in attaining the objects and benefits of the invention as desired. Examples of the arylborate of the arylborate salt include tetraphenylborate, tetra-p-methylphenylborate (i.e., tetra-p-tolylborate), tetra-p-fluorophenylborate, tetra-m-fluorophenylborate and tetramethoxyphenylborate, with tetraphenylborate and tetra-p-tolylborate being preferred.

The arylborate salt (C) may contain one member selected from among alkali metals, alkyl ammonium compounds, imidazolium compounds, arylphosphonium compounds, and alkylphosphonium compounds. Of these, arylphosphonium compounds are preferred.

Suitable arylphosphonium compounds include triphenylphosphine, tritolylphosphine, ethyldiphenylphosphine, butyldiphenylphosphine, benzyldiphenylphosphine, tetraphenylphosphonium salts, tetratolylphosphonium salts, ethyltriphenylphosphonium salts, butyltriphenylphosphonium salts, and benzyltriphenylphosphonium salts.

Preferred examples of the curing accelerant (C) include tetraphenylphosphonium tetraphenylborate, tetraphenylphosphonium tetra-p-tolylborate, and triphenylphosphine triphenylborane.
The curing accelerant (C) is preferably blended in an amount of 0.1 to 10 parts by weight, more preferably 0.2 to 5 parts by weight per 100 parts by weight of components (A) and (B) combined.
In addition to components (A) to (C), the epoxy resin composition may further contain (D) an inorganic filler and (E) other additives.

(D) Inorganic filler

The inorganic filler (D) is optionally added to the epoxy resin composition for the purposes of lowering a coefficient of thermal expansion and improving humidity reliability. Examples of the inorganic filler include silicas such as fused silica, crystalline silica, and cristobalite, alumina, silicon nitride, aluminum nitride, boron nitride, titanium oxide, glass fibers, and magnesium oxide. The average particle size and shape of the inorganic filler may be selected as appropriate depending on a particular application. Of these, spherical alumina, spherical fused silica and glass fibers are preferred.
The amount of the inorganic filler (D) is preferably 20 to 1,500 parts by weight, more preferably 50 to 1,000 parts by weight per 100 parts by weight of components (A) to (C) combined.

(E) Other additives

If necessary, other additives as component (E) may be added to the epoxy resin composition as long as the objects and benefits of the invention are not compromised. Exemplary additives include parting agents, flame retardants, ion trapping agents, antioxidants, adhesion promoters, stress reducing agents, and colorants.
The parting agent may be added for the purpose of improving mold release. Examples of the parting agent include well-known parting agents such as carnauba wax, rice wax, candelilla wax, polyethylene, polyethylene oxide, polypropylene, montanic acid, and montan waxes in the form of esters of montanic acid with saturated alcohols, 2-(2-hydroxyethylamino)ethanol, ethylene glycol or glycerol; stearic acid, stearic esters, and stearamides.
The flame retardant may be added for the purpose of imparting flame retardancy. The flame retardant is not particularly limited and any well-known flame retardants may be used. Examples include phosphazene compounds, silicone compounds, zinc molybdate on talc, zinc molybdate on zinc oxide, aluminum hydroxide, magnesium hydroxide, and molybdenum oxide.
The ion trapping agent may be added for the purposes of trapping ion impurities in the resin composition and preventing thermal degradation and moisture degradation. The ion trapping agent is not particularly limited and any well-known ion trapping agents may be used. Examples include hydrotalcites, bismuth hydroxide compounds, and rare earth oxides.
The stress reducing agent may be added for the purposes of preventing the resin from cracking, and reducing elasticity. Examples of the stress reducing agent include liquid silicone resins, liquid acrylic resins, liquid butadiene rubbers, solid silicone resins, solid acrylic resins, and solid butadiene rubbers.
Although the amount of component (E) may vary depending on the intended use of the epoxy resin composition, it is typically up to 10% by weight based on the total weight of the epoxy resin composition. The amount of component (E), if blended, is preferably at least 5% by weight.
The thermosetting epoxy resin composition may be prepared by the following method. For example, a resin mixture of components (A) to (C) may be obtained by mixing, stirring, dissolving and/or dispersing the epoxy resin (A), the aromatic amine-based curing agent (B), and the curing accelerant (C) simultaneously or separately, while heat treating if necessary. Also, a resin mixture of components (A) to (D) may be obtained by adding, stirring, dissolving and/or dispersing the inorganic filler (D) to the mixture of components (A) to (C). In certain applications, at least one additive (E) selected from parting agents, flame retardants, ion trapping agents and stress reducing agents may be added to and mixed with the mixture of components (A) to (C) or the mixture of components (A) to (D). Each of components (A) to (E) may be used alone or in admixture.
The method for preparing the resin mixture and the machine for mixing, stirring and dispersing are not particularly limited. Suitable machines include a mortar grinder, two-roll mill, three-roll mill, ball mill, planetary mixer, and MassColloider, equipped with stirring and heating units. These machines may be used in a suitable combination if desired.
When the epoxy resin composition is used as an encapsulant for semiconductor devices, it is preferably liquid at 25°C. By selecting the type and amount of the components, the viscosity of the epoxy resin composition is preferably controlled to a value of up to 1,000 Pa·s, specifically up to 500 Pa·s at 25°C as measured by an E type rotational viscometer at 1 rpm. The lower limit of viscosity is typically at least 1 Pa·s, though not critical.
The epoxy resin composition may be molded under standard conditions in accordance with standard methods. Preferably, the composition is molded and cured at 40 to 100°C and post-cured at 150 to 180°C for 1 to 3 hours. For example, it is desired to post-cure the composition by heating in an oven at 150°C for at least 1 hour. If the time of post

curing at 150°C is shorter than 1 hour, the cured product may have insufficient properties.

The epoxy resin composition is useful as an encapsulant, adhesive, and underfill material for semiconductor members. In particular, the composition may be advantageously used for encapsulating semiconductor devices such as diodes, transistors, ICs, LSIs, and VLSIs.

## EXAMPLE

Examples of the invention are given below by way of illustration and not by way of limitation.

### Examples 1 to 13 and Comparative Examples 1 to 6

In Examples 1 to 13 and Comparative Examples 1 to 6, thermosetting epoxy resin compositions were prepared by blending components as shown below in accordance with the formulations in Tables 1 and 2. In Tables 1 and 2, the amounts of components are expressed in parts by weight (pbw) and (B)/(A) ratio represents equivalents of amino groups in component (B) per equivalent of epoxy groups in component (A).

(A) Liquid epoxy resin

| | |
|---|---|
| (1) Epoxy resin (A1): | bisphenol A type epoxy resin (Epikote 828 from Mitsubishi Chemical Co., Ltd.) |
| (2) Epoxy resin (A2): | bisphenol A type epoxy resin/bisphenol F type epoxy resin (ZX1059 from Nippon Steel & Sumikin Chemical Co., Ltd.) |
| (3) Epoxy resin (A3): | aminophenol type trifunctional epoxy resin (jER630 from Mitsubishi Chemical Co., Ltd.) |

(B) Amine-based curing agent

(1) Aromatic amine-based curing agent (B1): 3,3'-diethyl-4,4'-diaminodiphenylmethane (KAYAHARD AA from Nippon Kayaku Co.,Ltd.)

(2) Aromatic amine-based curing agent (B2): diethyltoluenediamine (Ethacure100 from Albemarle Corporation)

(3) Alicyclic amine-based curing agent (B3): 1,3-bisaminomethylcyclohexane (1,3-BAC from Mitsubishi Gas Chemical Co., Inc.)

(C) Curing accelerant

(1) Tetraphenylphosphonium tetraphenylborate (C1): (TPP-K from Hokko Chemical Industry Co., Ltd.)

(2) Tetraphenylphosphonium tetra-p-tolylborate (C2): (TPP-MK from Hokko Chemical Industry Co., Ltd.)

(3) Triphenylphosphine triphenylborane (C3): (TPP-s from Hokko Chemical Industry Co., Ltd.)

(4) Triphenylphosphine (C4): (TPP from Hokko Chemical Industry Co., Ltd.)

(5) 2-Ethyl-4-methylimidazole (Shikoku Chemicals Corporation)

(6) Salicylic acid (Tokyo Chemical Industry Co., Ltd.)

(D) Inorganic filler

(1) Spherical silica having an average particle size of 2 μm

(2) Spherical silica having an average particle size of 13 μm (CS-6103 53C, Tatsumori Ltd.)

The compositions were evaluated by the methods described below, with the results shown in Tables 1 and 2.

Curability

For curability evaluation, the resin compositions prepared in Examples 1 to 13 and Comparative Examples 1 to 6 were each cast into a mold of 1 mm thick, allowed to stand in an oven at 120°C for 10 minutes, taken out of the oven, and cooled to room temperature. The sample was rated good "O" when no surface tack was observed and poor "X" when surface tack was observed or the sample was uncured. The results are shown in Tables 1 and 2.

Viscosity buildup rate

The resin compositions (samples) of Examples 1 to 13 and Comparative Examples 1 to 6 immediately after preparation were measured for viscosity by a cone-plate rotational viscometer (Type E viscometer) at a temperature of 25°C, after 2 minutes from sample loading, according to JIS Z-8803: 2011. This viscosity is referred to as initial viscosity (mPa·s). Also the resin compositions were held at 25°C for 8 hours and similarly measured for viscosity. A viscosity buildup rate (%) was computed from the following equation.

$$\text{Viscosity buildup rate (\%)} = [(\text{viscosity after 8 hr}) - (\text{initial viscosity})] / (\text{initial viscosity}) \times 100$$

The sample was rated good "O" when the viscosity buildup rate was within the range of 100% to 200% and poor "X" when the rate was more than 200%. The results are shown in Tables 1 and 2.

Preparation of cured sample

The epoxy resin compositions of Examples 1 to 13 and Comparative Examples 1 to 6 were liquid at 25°C before curing. Then test pieces (i.e., cured samples) subject to the following tests were prepared by molding and curing the compositions at 120°C for 1 hour.

Adhesion

A test piece was prepared by molding the composition over an area of 4 $mm^2$ on a silicon chip of 10 mm × 10 mm under the above conditions. For adhesion evaluation, the test piece was measured for shear bond strength at 150°C by a bond tester DAGE Series 4000PXY (DAGE). The bonded area between the test piece frame and the resin was 10 $mm^2$. The results are shown in Tables 1 and 2.

Adhesion retentivity after hot humid storage

The test piece (after 120°C/1 hr curing) was stored at 85°C/85% RH for 24 hours, then cooled to room temperature, and measured for shear bond strength by the same method as the initial adhesion. The adhesion retentivity (%) after hot humid storage was computed from the following equation.

$$\text{Adhesion retentivity (\%)} = (\text{shear bond strength after 85°C/85\% RH/24 hr storage}) / (\text{initial shear bond strength}) \times 100$$

The results are shown in Tables 1 and 2.

Table 1

| | | Example | | | | | | | | | |
|---|---|---|---|---|---|---|---|---|---|---|---|
| | | 1 | 2 | 3 | 4 | 5 | 6 | 7 | 8 | 9 | 10 |
| (B)/(A) ratio | | 1.0 | 1.0 | 1.0 | 1.0 | 1.0 | 1.0 | 1.0 | 1.0 | 1.0 | 1.0 |
| Composition (pbw) | Epoxy resin (A1) | 74.9 | 74.9 | 74.9 | 33.7 | | | 74.9 | 74.9 | 74.9 | 74.9 |
| | Epoxy resin (A2) | | | | | 72.3 | 79.2 | | | | |
| | Epoxy resin (A3) | | | | 33.7 | | | | | | |
| | Aromatic amine-based curing agent (B1) | 25.1 | 25.1 | 25.1 | 32.68 | 27.7 | | 25.1 | 25.1 | 25.1 | 25.1 |
| | Aromatic amine-based curing agent (B2) | | | | | | 20.8 | | | | |
| | Alicyclic amine-based curing agent (B3) | | | | | | | | | | |
| | Curing accelerant (C1) | 0.5 | | | | 0.5 | 1 | 3 | 5 | | |
| | Curing accelerant (C2) | | 0.5 | | | | | | | 3 | |
| | Curing accelerant (C3) | | | 0.5 | 0.5 | | | | | | 0.2 |
| | Curing accelerant (C4) | | | | | | | | | | |
| | Curing accelerant (C5) | | | | | | | | | | |
| | Curing accelerant (C6) | | | | | | | | | | |
| | Inorganic filler (D1) | | | | | | | | | | |
| | Inorganic filler (D2) | | | | | | | | | | |

(continued)

| | | Example | | | | | | | | | |
|---|---|---|---|---|---|---|---|---|---|---|---|
| | | 1 | 2 | 3 | 4 | 5 | 6 | 7 | 8 | 9 | 10 |
| Physical properties | Curability (120°C/10 minutes) | O | O | O | O | O | O | O | O | O | O |
| | Viscosity buildup rate (25°C/8 hr) | O | O | O | O | O | O | O | O | O | O |
| | Adhesion (MPa) | 14.1 | 15.2 | 22.1 | 18.7 | 15.5 | 8.7 | 15.3 | 15.9 | 16.2 | 19.3 |
| | Adhesion retentivity after hot humid storage (%) | 94 | 95 | 99 | 94 | 95 | 89 | 95 | 95 | 95 | 97 |

Table 2

| | | Example | | | Comparative Example | | | | | |
|---|---|---|---|---|---|---|---|---|---|---|
| | | 11 | 12 | 13 | 1 | 2 | 3 | 4 | 5 | 6 |
| (B)/(A) ratio | | 1.0 | 1.0 | 1.0 | 1.0 | 1.0 | 1.0 | 1.0 | 0.5 | 2.0 |
| Composition (pbw) | Epoxy resin (A) | 74.9 | 74.9 | 74.9 | 74.9 | 74.9 | 74.9 | 84.2 | 59.8 | 85.6 |
| | Epoxy resin (A2) | | | | | | | | | |
| | Epoxy resin (A3) | | | | | | | | | |
| | Aromatic amine-based curing agent (B1) | 25.1 | 25.1 | 25.1 | 25.1 | 25.1 | 25.1 | | 40.2 | 14.4 |
| | Aromatic amine-based curing agent (B2) | | | | | | | | | |
| | Alicyclic amine-based curing agent (B3) | | | | | | | 15.8 | | |
| | Curing accelerant (C1) | | | | | | | | 0.5 | 0.5 |
| | Curing accelerant (C2) | | | | | | | 0.5 | | |
| | Curing accelerant (C3) | 0.2 | 0.2 | 0.2 | | | | | | |
| | Curing accelerant (C4) | | | | 5 | | | | | |
| | Curing accelerant (C5) | | | | | 1 | | | | |
| | Curing accelerant (C6) | | | | | | 0.5 | | | |
| | Inorganic filler (D1) | 25.05 | 100.2 | | | | | | | |
| | Inorganic filler (D2) | | | 670.6 | | | | | | |
| Physical properties | Curability (120°C/10 minutes) | O | O | O | x | x | x | O | X | x |
| | Viscosity buildup rate (25°C/8 hr) | O | O | O | O | x | x | unmeasurable | X | O |
| | Adhesion (MPa) | 18.3 | 21.2 | 18.8 | 4.3 | 6.1 | 5.2 | 5.6 | 5.2 | uncured |
| | Adhesion retentivity after hot humid storage (%) | 95 | 98 | 99 | 38 | 65 | 44 | 33 | 37 | |

## Claims

1. An epoxy resin composition, which is liquid at 25°C, comprising

    (A) an epoxy resin,
    (B) an aromatic amine-based curing agent, and
    (C) a curing accelerant,

    an equivalent ratio of amino groups in the aromatic amine-based curing agent (B) to epoxy groups in the epoxy resin (A) being from 0.7/1 to 1.5/1 and the curing accelerant (C) comprising an arylborate salt, wherein component (B) is at least one aromatic amine-based curing agent selected from the formulae (1), (2), (3) and (4):

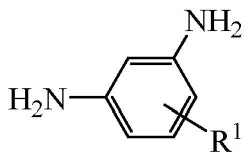

(1)

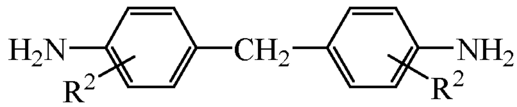

(2)

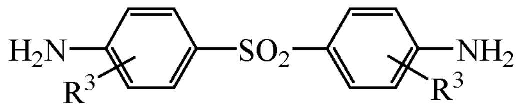

(3)

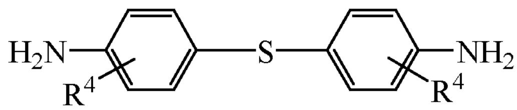

(4)

    wherein $R^1$ is selected from $C_1$-$C_6$ monovalent hydrocarbon groups, $CH_3S$-, and $CH_3CH_2S$-, and $R^2$ to $R^4$ which may be the same or different are selected from hydrogen, $C_1$-$C_6$ monovalent hydrocarbon groups, $CH_3S$-, and $CH_3CH_2S$-.

2. The epoxy resin composition of claim 1 wherein the arylborate salt as component (C) contains at least one member selected from the group consisting of alkali metals, alkyl ammonium compounds, imidazolium compounds, arylphosphonium compounds, and alkylphosphonium compounds.

3. The epoxy resin composition of claim 1 or 2 wherein component (C) is tetraphenylphosphonium tetraphenylborate, tetraphenylphosphonium tetra-p-tolylborate or triphenylphosphine triphenylborane.

4. The epoxy resin composition of any one of claims 1 to 3 wherein component (C) is blended in an amount of 0.1 to 10 parts by weight per 100 parts by weight components (A) and (B) combined.

5. The epoxy resin composition of any one of claims 1 to 4 wherein the epoxy resin (A) is a liquid epoxy resin.

6. The epoxy resin composition of any one of claims 1 to 5, further comprising (D) an inorganic filler.

7. A semiconductor device encapsulated with the epoxy resin composition of any one of claims 1 to 6 in the cured state.

## Patentansprüche

1. Epoxidharzzusammensetzung, die bei 25 °C flüssig ist, umfassend

(A) ein Epoxidharz,
(B) ein Härtungsmittel auf aromatischer Aminbasis und
(C) einen Härtungsbeschleuniger,

wobei ein Äquivalentverhältnis von Aminogruppen in dem Härtungsmittel auf aromatischer Aminbasis (B) zu Epoxidgruppen in dem Epoxidharz (A) von 0,7/1 bis 1,5/1 beträgt und der Härtungsbeschleuniger (C) ein Arylboratsalz umfasst, wobei Komponente (B) wenigstens ein Härtungsmittel auf aromatischer Aminbasis ist, ausgewählt aus den Formeln (1), (2), (3) und (4):

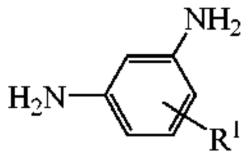

(1)

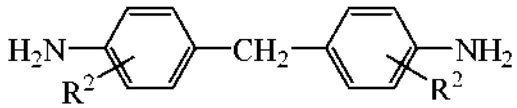

(2)

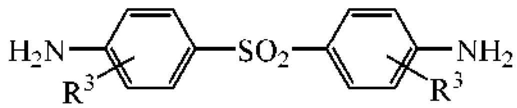

(3)

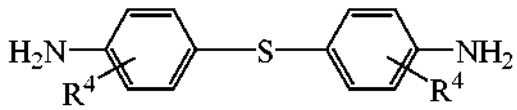

(4)

wobei $R^1$ aus einwertigen $C_1$-$C_6$-Kohlenwasserstoffgruppen, $CH_3S$- und $CH_3CH_2S$-ausgewählt ist, und $R^2$ bis $R^4$, die gleich oder verschieden sein können, aus Wasserstoff, einwertigen $C_1$-$C_6$-Kohlenwasserstoffgruppen, $CH_3S$- und $CH_3CH_2S$- ausgewählt sind.

**2.** Epoxidharzzusammensetzung nach Anspruch 1, wobei das Arylboratsalz als Komponente (C) wenigstens ein Element enthält, das aus der Gruppe ausgewählt ist, die aus Alkalimetallen, Alkylammoniumverbindungen, Imidazoliumverbindungen, Arylphosphoniumverbindungen und Alkylphosphoniumverbindungen besteht.

**3.** Epoxidharzzusammensetzung nach Anspruch 1 oder 2, wobei Komponente (C) Tetraphenylphosphoniumtetraphenylborat, Tetraphenylphosphoniumtetra-p-tolylborat oder Triphenylphosphintriphenylboran ist.

**4.** Epoxidharzzusammensetzung nach einem der Ansprüche 1 bis 3, wobei Komponente (C) in einer Menge von 0,1 bis 10 Gewichtsteilen pro 100 Gewichtsteilen der Komponenten (A) und (B) zusammen gemischt wird.

**5.** Epoxidharzzusammensetzung nach einem der Ansprüche 1 bis 4, wobei das Epoxidharz (A) ein flüssiges Epoxidharz ist.

**6.** Epoxidharzzusammensetzung nach einem der Ansprüche 1 bis 5, ferner umfassend (D) einen anorganischen Füllstoff.

**7.** Halbleitervorrichtung, die mit der Epoxidharzzusammensetzung nach einem der Ansprüche 1 bis 6 in dem ausgehärteten Zustand verkapselt ist.

**Revendications**

1. Composition de résine époxy, liquide à 25 °C, comprenant

    (A) une résine époxy,
    (B) un agent de durcissement à base d'amine aromatique, et
    (C) un accélérateur de durcissement,

    un rapport équivalent de groupes amino dans l'agent de durcissement à base d'amine aromatique (B) par rapport aux groupes époxy dans la résine époxy (A) étant compris entre 0,7/1 et 1,5/1 et l'accélérateur de durcissement (C) comprenant un sel arylborate, le composant (B) représentant au moins un agent de durcissement à base d'amine aromatique choisi parmi les formules (1), (2), (3) et (4) :

    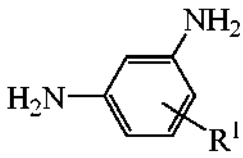
    (1)

    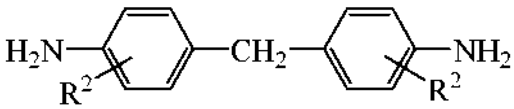
    (2)

    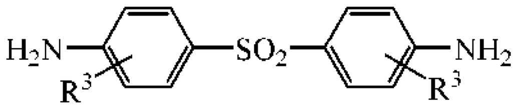
    (3)

    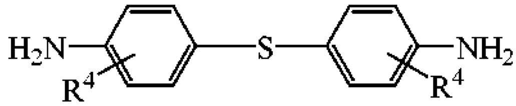
    (4)

    $R^1$ étant choisi parmi les groupes hydrocarbonés monovalents en $C_1$ à $C_6$, $CH_3S$- et $CH_3CH_2S$-, et $R^2$ à $R^4$, qui peuvent être identiques ou différents, étant choisis parmi l'hydrogène, les groupes hydrocarbonés monovalents en $C_1$ à $C_6$, $CH_3S$- et $CH_3CH_2S$-.

2. Composition de résine époxy selon la revendication 1, dans laquelle le sel arylborate en tant que composant (C) contient au moins un constituant choisi dans le groupe constitué par les métaux alcalins, les composés d'alkylammonium, les composés d'imidazolium, les composés d'arylphosphonium et les composés d'alkylphosphonium.

3. Composition de résine époxy selon la revendication 1 ou 2, dans laquelle le composant (C) est le tétraphénylborate de tétraphénylphosphonium, le tétra-p-tolylborate de tétraphénylphosphonium ou la triphénylphosphine-triphénylborane.

4. Composition de résine époxy selon l'une quelconque des revendications 1 à 3, dans laquelle le composant (C) est mélangé en une quantité de 0,1 à 10 parties en poids pour 100 parties en poids des composants (A) et (B) combinés.

5. Composition de résine époxy selon l'une quelconque des revendications 1 à 4, dans laquelle la résine époxy (A) est une résine époxy liquide.

6. Composition de résine époxy selon l'une quelconque des revendications 1 à 5, comprenant en outre (D) une charge inorganique.

7. Dispositif semi-conducteur encapsulé à l'aide de la composition de résine époxy selon l'une quelconque des revendications 1 à 6 à l'état durci.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2017093663 A
- JP 2016060826 A
- JP 2015113426 A